# EUROPÄISCHE PATENTSCHRIFT

(11) **EP 0 422 560 B1**
(45) Veröffentlichungstag und Bekanntmachung des Hinweises auf die Patenterteilung: **10.05.1995**
(21) Anmeldenummer: 90119262.5
(22) Anmeldetag: 08.10.1990
(51) Int. Cl.: H03M 13/12, H03M 13/00

(54) **Verfahren zum Codieren und Decodieren von binären Daten sowie Einrichtung zur Durchführung des Verfahrens**
Method for coding and decoding of binary datas and arrangement for the realization of this method
Procédé pour coder et décoder des données binaires et arrangement pour la réalisation de ce procédé

(30) Priorität: 10.10.1989 DE 3933822
(43) Veröffentlichungstag der Anmeldung: 17.04.1991
(73) Patentinhaber: Deutsche Forschungsanstalt für Luft- und Raumfahrt e.V., 51126 Köln (DE)
(72) Erfinder: Schweikert, Robert, Dr., W-8031 Seefeld (DE); Vinck, Adrianus, Prof., NL-5641 PJ Eindhoven (NL)
(74) Vertreter: von Kirschbaum, Albrecht, Dipl.-Ing.

(56) Entgegenhaltungen:
- EP-A- 0 225 735
- US-A- 4 545 054
- US-A- 4 709 377
- G.C. Clark, J.B. Cain, "Error-Correction Coding for Digital Communications", Plenum Press, New York, 1981, Seiten 339 und 340

## Beschreibung

Die Erfindung betrifft ein Verfahren zum Codieren und Decodieren von binären Daten nach dem Oberbegriff des Anspruchs 1 sowie eine Einrichtung zur Durchführung des Verfahrens nach dem Oberbegriff des Anspruchs 2.

Durch Störungen auf einer Übertragungsstrecke und durch Empfänger-Eigenrauschen werden bei einer digitalen Datenübertragung binäre Informationseinheiten, d.h. die einzelnen Bits, verfälscht. Die Rate, mit welcher solche fehlerhaften Bits auftreten, d.h. die Bitfehlerrate (BER) hängt von dem benutzten Übertragungsverfahren und von Kanalstörungen ab und ist eine Funktion des Signal-Rauschabstandes.

In Bereichen der Kommunikation, die vor allem, wie beispielsweise in der Kommunikation über Satelliten, durch eine Leistungsbegrenzung charakterisiert sind, ist es üblich und vorteilhaft, zur Fehlerkorrektur Kanal-Codierverfahren anzuwenden. Mit Hilfe solcher Verfahren kann daher bei einem gegebenen Signal-Rauschabstand die Bitfehlerrate (BER) verbessert oder, was gleichbedeutend ist, für eine bestimmte Bitfehlerrate kann der erforderliche Signal-Rauschabstabd reduziert werden. Diese Reduktion des erforderlichen Signal-Rauschabstandes wird als Codegewinn bezeichnet. Bei fehlerkorrigierenden Codes werden u.a. sogenannte Block- und Faltungscodes unterschieden.

Für sehr mächtige Faltungscodes, d.h. für Faltungscodes mit großer freier Distanz, (mit den hierfür erforderlichen Einflußlängen K > 7) ist eine Maximum-Likelyhood-Decodierung mittels eines Viterbi-Algorithmus bei hohen Datenraten nur schwer zu realisieren. Bei einer Kombination verschiedener Codes, die beispielsweise die einen Produktcode mit gleicher Mächtigkeit (freier Distanz) ergibt, ist eine gemeinsame Soft-Decision-Decodierung des Gesamtcodes sehr aufwendig, während eine getrennte Decodierung der einzelnen Codes mit geringerem Aufwand zu realisieren ist, jedoch zu beachtlichen Verlusten bezüglich des Codegewinns führt. (Siehe G.C. Clark, J.B. Cain, "Error-Correction Coding for Digital Communications", Plenum Press, New York 1981, Stn. 331 und 332.

Aufgabe der Erfindung ist es daher, eine sendeseitige Codierung binärer Daten mit Hilfe einer Kombination verschiedener, zweckmäßiger Codes derart vorzunehmen, daß empfangsseitig ebenfalls mit geringem Aufwand, jedoch ohne einen Verlust bezüglich des Codegewinns eine Decodierung der gewählten Codekombination bei hohen Datenraten durchführbar ist.

Gemäß der Erfindung ist dies bei einem Verfahren zum Codieren und Decodieren von binären Daten durch die Merkmale im kennzeichnenden Teil des Anspruchs 1 erreicht. Ferner ist eine Einrichtung zur Durchführung des Verfahrens durch die Merkmale im kennzeichnenden Teil des Anspruchs 2 realisiert.

Die Aufgabe ist gemäß der Erfindung dadurch gelöst, daß sendeseitig eine Codierung der Daten mit einer Codekombination aus einem Faltungscode und einem einfachen Blockcode in Form eines Single-Parity-Check(SPC)-Code durchgeführt, werden empfangsseitig eine gemeinsame Soft-Decision-Decodierung mittels Viterbi-Decoder, SPC-Decoder und Nachverarbeitung in der Weise vorgenommen wird, daß mit dem erfindungsgemäßen Verfahren sowie mit der erfindungsgemäßen Einrichtung zur Durchführung des Verfahrens Übertragungen mit hohen Datenraten dadurch erreicht werden, daß nach der parallelen Viterbi-Decodierung mittels eines SPC-Codes empfangsseitig eine Paritätsprüfung vorgenommen wird. Bei Feststellen eines Fehlerereignisses bei der Paritätsprüfung wird dann gemäß der Erfindung eine Nachbearbeitung in der Weise durchgeführt, daß parallel eine Faltungscodierung einer Sequenz mit Paritätsverletzung und eine erneute Faltungscodierung von in den Viterbi-Decodern bereits decodierten Eingangssignalen durchgeführt wird und dann aus diesen erneut faltungscodierten Sequenzen und der eine Paritätsverletzung aufweisenden Sequenz zuerst Modulo-2-Summen gebildet werden.

Hierauf wird dann eine Veränderung von Euklid'schen Distanzen zwischen Sequenzen aus unbehandelten, analogen Eingangssignalen und aus den erneut faltungscodierten Sequenzen einerseits sowie den gerade gebildeten Modulo-2-Summen bestimmt. Hierauf wird das Minimum der Veränderungen aller Euklid'schen Distanzen gesucht und festgestellt und mit Hilfe der Paritätsverletzungen aufweisenden Sequenz werden schließlich zur Fehlerkorrektur Bits in einer der decodierten Sequenzen invertiert.

Aufgrund der Kombination eines einfachen Codes, nämlich eines Blockcodes in Form eines Single-Parity-Check(SPC)-Codes und eines aufwendigeren fehlerkorrigierenden Codes, nämlich eines Faltungscodes sind die Eigenschaften der einfachen SPC-Codierung zur Reduktion der Komplexität der anderen, erheblich aufwendigeren Faltungscodierung in der Weise genutzt, daß ohne wesentlichen Verlust bezüglich des Codegewinns auch bei hohen Datenraten eine schnelle Decodierung durchgeführt werden kann.

Nachfolgend wird die Erfindung anhand einer bevorzugten Ausführungsform einer erfindungsgemäßen Einrichtung zur Durchführung des Verfahrens im einzelnen anhand der Zeichnungen erläutert. Es zeigen:

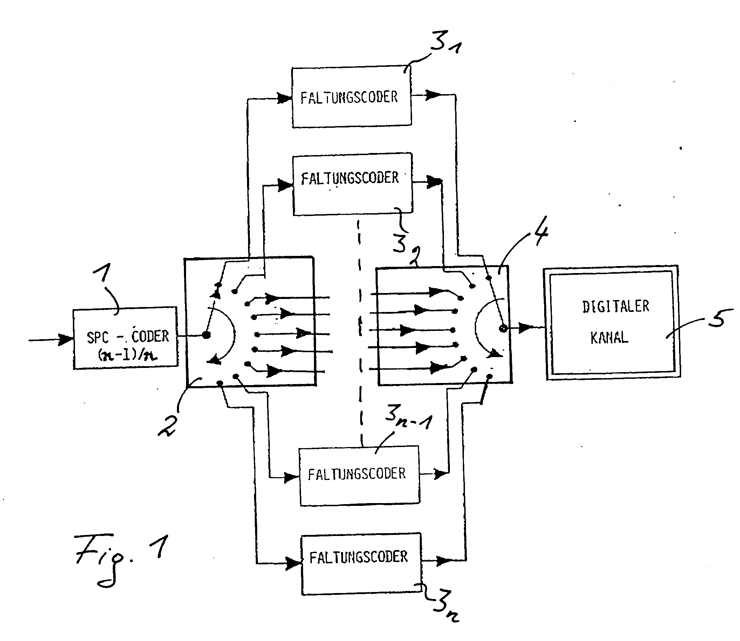

- Fig.1: ein schematisiertes Blockschaltbild einer sendeseitigen Codieranordnung der erfindungsgemäßen Einrichtung zur Durchführung des Verfahrens;
- Fig.2: ein schematisiertes Blockschaltbild einer Decodieranordnung der erfindungsgemäßen Einrichtung zur Durchführung des erfindungsgemäßen Verfahrens, und
- Fig.3: eine Kurvendarstellung, in welcher die gemessene Bitfehlerrate (BER) nach einer Codierung mittels der erfindungsgemäßen Einrichtung als Funktion des Verhältnisses von Energie pro Informationsbit (E_{b}) zur einseitigen Rauschleistungsdichte (Nₒ) bei einer codierten Übertragung bei Anwendung von kokärenter PSK-Modulation in einem Kanal mit additivem, weißem Gauß'schen Rauschen (AWGN) aufgetragen ist.

Wie in dem schematischen Blockschaltbild einer sendeseitigen Codieranordnung der erfindungsgemäßen Einrichtung zur Durchführung des Verfahrens dargestellt ist, werden sendeseitig binäre Eingangsdaten an einen [(n-1)/n] SPC-Coder 1 angelegt, wie durch einen nach rechts weisenden Pfeil auf der linken Seite des Blockes 1 angedeutet ist. Wie beispielsweise in dem deutschen Patent DE 37 18 632 C1 im einzelnen beschrieben ist, werden die binären Eingangsdaten in dem SPC-Coder 1 codiert und dann über einen schematisch dargestellten Demultiplexer 2 demultiplext und so aufgeteilt, daß sie n Faltungscodern 3₁ bis 3ₙ zugeführt werden. Bei diesen Faltungscodern kann es sich i.a. um Coder zur Realisierung unterschiedlicher, aber linearer Faltungscodes mit unterschiedlichen Coderaten handeln. Im folgenden ist jedoch angenommen, daß es sich um gleichartige Faltungscoder bzw. um Faltungscodes handelt, obwohl natürlich eine Verallgemeinerung auf unterschiedliche Codes ohne weiteres möglich ist.

Die Ausgänge der n Faltungscoder 3₁ bis 3ₙ werden einem schematisiert dargestellten Multiplexer 4 zugeführt, welcher mit einem digitalen Kanal 5 verbunden ist, über welchen die entsprechend aufbereiteten, binären Daten dann übertragen werden.

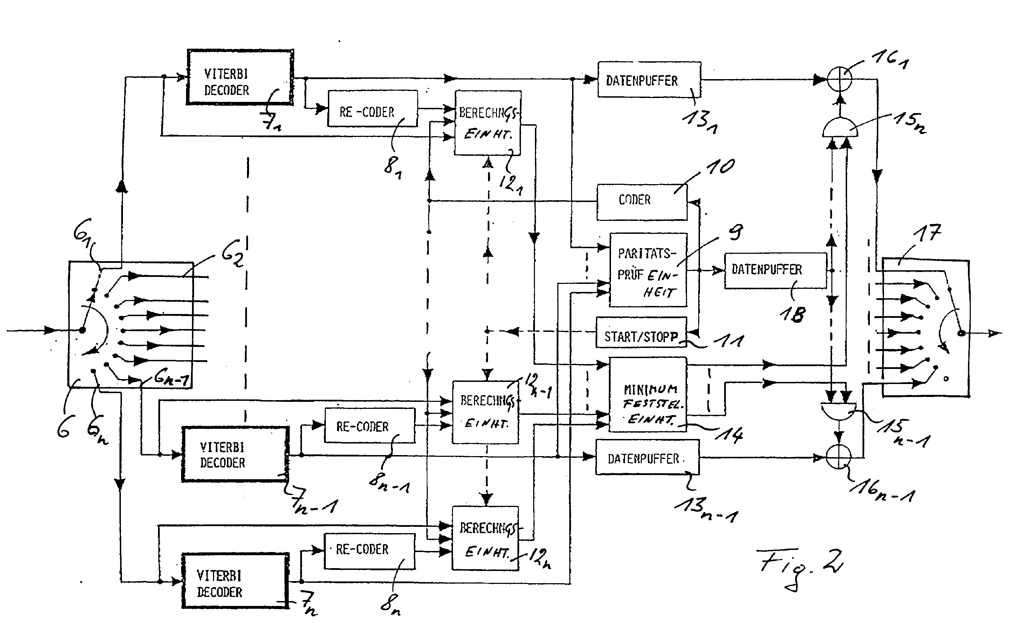

Auf der Empfangsseite werden dann die über den digitalen Kanal 5 übertragenen Daten an der Eingangsseite eines Empfängers zuerst einer Quantisierung unterzogen; anschließend werden die quantisierten Empfangswerte in einem Demultiplexer 6 demultiplext, welcher in dem Blockschaltbild einer Decodieranordnung der erfindungsgemäßen Einrichtung in Fig.2 auf der linken Seite schematisiert wiedergegeben ist. Der Demultiplexer 6 gleicht den zeitlichen Versatz seiner einzelnen Kanäle aus, so daß alle seine Ausgänge im Takt von 1/n der Kanal-Datenrate Werte abgeben.

Die Ausgänge 6₁ bis 6ₙ des Demultiplexers 6 sind mit n Viterbi-Decodern 7₁ bis 7ₙ verbunden, in welchen folglich die Daten nur mit einer Geschwindigkeit von 1/n der Kanal-Datenrate decodiert werden können. Die Ausgänge der n Viterbi-Decoder 7₁ bis 7ₙ werden einer Paritäts-Prüfeinheit 9 zugeführt, in welcher sie mit Hilfe des SPC-Codes einer Paritätsprüfung unterworfen werden. Das Ergebnis der Paritätsprüfung wird dann einer nachstehend im einzelnen erläuterten Nachverarbeitung unterzogen.

Bei dieser Nachverarbeitung werden folgende Operationen durchgeführt. Sobald Paritätsverletzungen in der Paritätsprüfeinheit 9 festgestellt werden, wird die Sequenz von Paritätsverletzungen mittels eines den sendeseitig verwendeten Faltungcodern 3₁ bis 3ₙ entsprechenden Faltungscoders 10 faltungscodiert. Ferner werden die mittels der Viterbi-Decoder 7₁ bis 7ₙ bereits decodierten Sequenzen in ebenfalls den sendeseitig verwendeten Faltungscodern 3₁ bis 3ₙ entsprechenden Faltungscodern 8₁ bis 8ₙ erneut faltungscodiert, weshalb die Faltungscoder 8₁ bis 8ₙ in Fig.2 als RE-CODER bezeichnet sind. Gesteuert durch eine ebenfalls mit dem Ausgang der Paritäts-Prüfeinheit 9 verbundenen Start/Stopp-Einheit 11 werden dann die mittels des Coders 10 faltungscodierten, Paritätsverletzungen enthaltenden Sequenzen zusammen mit den in den RE-CODERN 8₁ bis 8ₙ erneut faltungscodierten Sequenzen an n Berechnungseinheiten 12₁ bis 12ₙ angelegt, in welchen aus den erneut faltungscodierten Sequenzen Ausgangssequenzen der RE-CODER 8 und der faltungscodierten Sequenz der Paritätsverletzungen Modulo-2-Summen gebildet werden.

Da ferner die unbehandelten wertkontinuierlichen und zeitdiskreten Ausgangswerte des Demultiplexers 6 unter Umgehung der Viterbi-Decoder 7₁ bis 7ₙ unbehandelt an den Berechnungseinheiten 12₁ bis 12ₙ anliegen, kann in diesen Einheiten 12₁ bis 12ₙ ferner jede Veränderung der Euklid'schen Distanzen zwischen den Sequenzen der unveränderten, weitgehend analogen, wertkontinuierlichen und zeitdiskreten Ausgangswerte des Demultiplexers 6 und den in den RE-CODERN 8₁ bis 8ₙ erneut faltungscodierten Sequenzen einerseits sowie den in den Berechnungseinheiten 12₁ bis 12ₙ ständig im Takt 1/n der Kanalrate quer über alle n parallelen Sequenzen gebildeten Modulo-2-Summen andererseits bestimmt werden. Die Berechnungen in den Einheiten 12₁ bis 12ₙ werden nur dann durchgeführt, wenn, wie vorstehend bereits erwähnt, in der Paritäts-Prüfeinheit 9 mit Hilfe des SPC-Codes Fehlerereignisse festgestellt worden sind und daraufhin die Berechnungseinheiten 12₁ bis 12ₙ über die Start/ Stopp-Einheit 11 jeweils aktiviert worden sind.

Die Start/Stopp-Einheit 11 alterniert alle Berechnungseinheiten nach Eintreten eines Fehlerereignisses. Ein Fehlerereignis beginnt mit einer Eins in der Ausgangssequenz der Paritätsprüfeinheit 9 und endet mit k-1 aufeinanderfolgenden Nullen in der Ausgangssequenz der Paritätsprüfeinheit 9. Nach Beendigung eines Fehlerereignisses versetzt die Start/Stopp-Einheit die Berechnungseinheiten 12₁ bis 12ₙ in einen Bereitschaftszustand.

Ausgangsseitig sind die Berechnungseinheiten 12₁ bis 12ₙ mit einer das Minimum feststellenden Einheit 14 verbunden. In der Einheit 14 wird das Minimum aller n Ausgänge der Berechnungseinheiten 12₁ bis 12ₙ gesucht. Die n Ausgangswerte der das Minimum feststellenden Einheit 14 werden zusammen mit der Paritätsverletzungen enthaltenden Sequenz am Ausgang der Paritätsprüfeinheit 9 über einen Datenpuffer 18 zum Ausgleich der Verarbeitungsverzögerung an die beiden Eingänge von (n-1) UND-Gliedern 15₁ bis 15ₙ₋₁ angelegt. Die Ausgangswerte der UND-Einheiten 15₁ bis 15ₙ₋₁ werden an Addiereinheiten 16₁ bis 16ₙ₋₁angelegt, die mit einem am Ausgang vorgesehenen Multiplexer 17 verbunden sind, und an deren zweiten Eingang die mittels der Viterbi-Decoder 7₁ bis 7ₙ decodierten und über nachgeordnete Datenpuffer 13₁ bis 13ₙ₋₁ gepufferten, decodierten Ausgangswerte anliegen. Die an den UND-Gliedern 15₁ bis 15ₙ₋₁ anliegenden Sequenzen dienen somit als Kriterium für die Inversion von Bits, in einer der über die Datenpuffer 13₁ bis 13ₙ₋₁ zugeführten, decodierten Sequenzen, so daß aufgrund der bei der Erfindung vorgesehenen Nachverarbeitung mit hohen Datenraten eine Fehlerkorrektur durchgeführt ist. Die Sequenz der Paritätsverletzungen bestimmt den Zeitpunkt, und der Ausgang der das Minimum feststellenden Einheit 14 wählt einen Zweig aus n Zweigen aus.

Das erfindungsgemäße Verfahren sowie die erfindungsgemäße Einrichtung zur Durchführung dieses Verfahrens können in vorteilhafter Weise weitergebildet und ausgestaltet werden. So kann beispielsweise bei Verwendung gleichartiger linearer Faltungscodes ein in dem deutschen Patent DE 37 18 632 C1 im einzelnen beschriebener SPC-Coder zu Synchronisationszwecken bereits vor den in Fig.2 wiedergegebenen Viterbi-Decodern 7₁ bis 7ₙ eingesetzt werden. Auf diese Weise kann dann eine Wortsynchronisation des SPC-Codes und ferner eine sogenannte Branch-Synchronisation der Faltungscodes erreicht werden. Hierbei muß jedoch sendeseitig die Parität von Wort zu Wort in entsprechender Weise geändert werden.

Ferner kann das erfindungsgemäße Verfahren auch bei Übertragungssystemen angewendet werden, bei denen eine Phasen-Mehrdeutigkeit vorkommt; hierbei ist dann die in dem erwähnten deutschen Patent DE 37 18 632 C1 beschriebene Strategie zur Auflösung von Fehlern bei Phasenmehrdeutigkeit anzuwenden.

Außerdem kann das erfindungsgemäße Verfahren auch in Fällen angewendet werden, bei welchen eine Wortsynchronisation durchzuführen ist und bei denen auch Fehler aufgrund einer Phasen-Mehrdeutigkeit auftreten, wenn hierbei in der nachstehend beschriebenen Weise verfahren wird. Eine Folge von Paritäten in dem Parity-Check-Codewort wird entsprechend gewählt, beispielsweise wird die Periode einer geraden, geraden, geraden, ungeraden Parität usw. so gewählt, daß sowohl der Wort-Synchronisationszustand und somit auch die vorstehend erwähnte Branch-Synchronisation als auch die durch eine Phasenmehrdeutigkeit verursachte Bit-Inversion anhand der Paritäts-Fehlerrate erkennbar wird. Hierbei beträgt im nicht-wortsynchronisierten Zustand die Paritäts-Fehlerrate 1/2, während im synchronisierten Zustand die Rate 0 ist oder bei einer Bit-Inversion 1 beträgt.

Schließlich kann für Datenquellen mit unterschiedlich wichtigen und daher auch unterschiedlich gegen Fehler zu schützenden Bits, wie beispielsweise der Wortausgang eines Analog-Digital-(A/D-)Wandlers, durch eine entsprechende Wahl unterschiedlicher Codes eine sogenannte adaptierte Fehlersicherung (unequal error protection) erzielt werden.

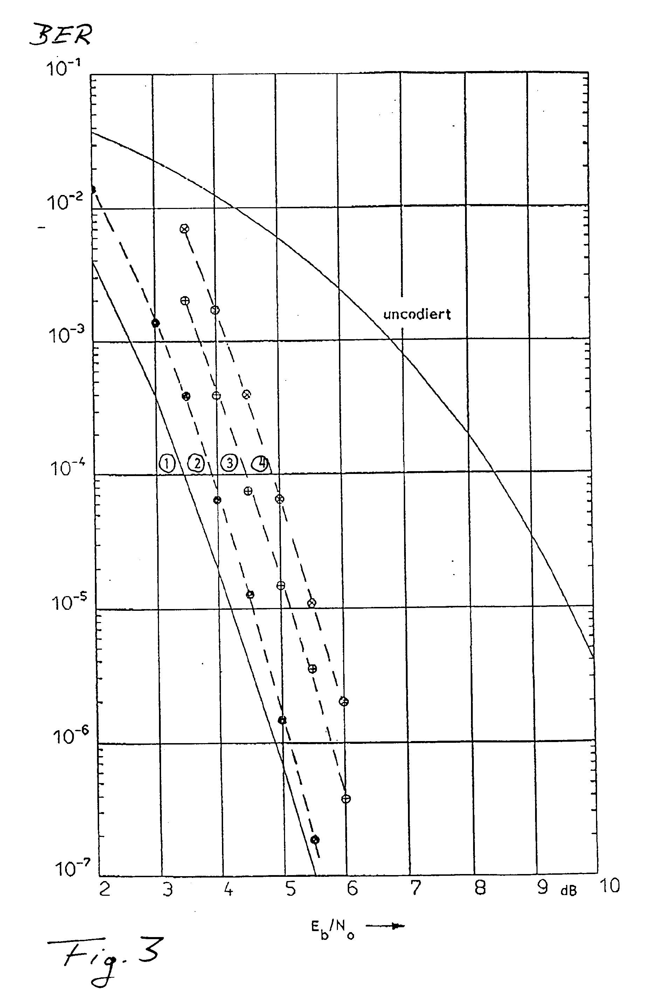

In Fig.3 ist in mehreren Kurven die Bit-Fehlerrate (BER) als Funktion eines Verhältnisses von Energie pro Informationsbit E_{b} zur einseitigen Rauschleistungsdichte Nₒ für eine digitale Übertragung in einem Kanal, beispielsweise dem digitalen Kanal 5 mit additivem, weißen Gauß'schen Rauschen (AWGN) bei Verwendung von kohärenter, d.h. binärer bzw. quarternärer PSK-Modulation dargestellt. Bei allen Kurven wurde ein SPC-Code der Länge n = 12 benutzt.

Hierbei stellt die mit 1 bezeichnete Kurve eine Abschätzung der Bit-Fehlerrate für einen Faltungscode mit einer Soft-Decision-Viterbi-Decodierung und einer Einflußlänge K = 7 und einer Rate R = 1/2 dar.

Bei der mit 2 bezeichneten, gestrichelt wiedergegebenen Kurve hatten die Faltungscodes eine Einflußlänge K = 3, die Rate R betrug 1/2, die freie Distanz betrug d_{free} = 5, woraus sich eine Gesamtcoderate R ≅ 0,46 ergab. Bei der mit 3 bezeichneten Kurve hatten die Faltungscodes eine Einflußlänge K = 3 und waren auf eine Rate von 2/3 gelocht; die freie Distanz d_{free} betrug 3, wobei sich dann eine Gesamt-Coderate R ≅ 0,61 ergab. Schließlich ist bei der mit 4 bezeichneten Kurve ein Faltungscode verwendet worden, der eine Einflußlänge K = 3 hatte und auf eine Rate von 3/4 gelocht war; die freie Distanz d_{free} betrug in diesem Fall 3 und daraus ergab sich eine Gesamt-Coderate R ≅ 0,69.

Der Pfadspeicher der verwendeten Viterbi-Decoder hatte eine Länge von 20 und die Sequenz von Paritätsverletzungen wurde 15 Bits lang betrachtet. Die mit dem erfindungsgemäßen Verfahren erreichte Verbesserung des Verhältnisses E_{b}/Nₒ ist sofort aus einem Vergleich der Kurven 2 bis 4 und der mit 1 bezeichneten Kurve zu ersehen, welche, wie vorstehend bereits ausgeführt, das Ergebnis für eine Soft-Decision Viterbi-Decodierung eines Faltungscodes der Rate 1/2 und mit einer Einflußlänge K = 7 ist.

Zu Vergleichszwecken ist rechts oben eine Kurve für eine vollkommen uncodierte Übertragung wiedergegeben.

## Patentansprüche

1. Verfahren zum Codieren und Decodieren von binären Daten unter Verwendung verketteter Codes, wobei sendeseitig eine Codierung der Daten mittels einer Codekombination aus einem einfachen Blockcode in Form eines Single-Parity-Check(SPC)-Codes und anschließend einem Faltungscode durchgeführt wird, und empfangsseitig Eingangssignale decodiert werden, dadurch **gekennzeichnet,** daß
empfangsseitig die Eingangssignale mittels parallel geschalteter Viterbi-Decoder decodiert und mittels eines SPC-Codes anschließend einer Paritätsprüfung unterzogen werden, und
bei Feststellen eines Fehlerereignisses eine Nachbearbeitung dergestalt durchgeführt wird, daß
nach einer Faltungscodierung der Sequenz der Paritätsverletzungen und nach einer erneuten Faltungscodierung von in den Viterbi-Decodern bereits decodierten Eingangssignalen mit den sendeseitigen Faltungscodes zuerst Modulo-2-Summen aus den erneut faltungscodierten Sequenzen und der faltungscodierten Sequenz der Paritätsverletzungen gebildet werden,
anschließend eine Veränderung von Euklid'schen Distanzen zwischen Sequenzen der unbehandelten, analogen Eingangssignale und den erneut faltungscodierten Sequenzen einerseits und von Euklid'schen Distanzen zwischen Sequenzen der unbehandelten analogen Eingangssignale und den gerade gebildeten Modulo-2-Summen andererseits bestimmt wird, und
schließlich nach Suchen und Feststellen des Miminimums der Veränderungen aller Euklid'schen Distanzen und mit Hilfe der faltungscodierten Sequenz der Paritätsverletzungen zur Fehlerkorrektur Bits in einer der mittels der Viterbi-Decoder decodierten Sequenzen invertiert werden.

2. Einrichtung zur Durchführung des Verfahrens nach Anspruch 1, in der sendeseitig einem [(n-1)/n] SPC-Coder (1) über einen Demultiplexer (2) n-Faltungscoder (3₁ bis 3ₙ) und diesen (3₁ bis 3ₙ) ein Multiplexer (4) nachgeschaltet sind, und empfangsseitig einer Quantisiereinheit und einem Demultiplexer (6) n Soft-Decision-Viterbi-Decoder (7ₐ bis 7ₙ) nachgeschaltet sind,
dadurch **gekennzeichnet,** daß
die Ausgänge der n-Soft-Decision-Viterbi-Decoder (7ₐ bis 7ₙ) mit einer Paritäts-Prüfeinheit (9) sowie parallel hierzu mit n Faltungscodern (8₁ bis 8ₙ) und (n-1) Datenpuffern (13₁ bis 13ₙ₋₁) verbunden sind,
der Ausgang der Paritäts-Prüfeinheit (9) zum einen über einen Datenpuffer (15) mit (n-1) UND-Gliedern (15₁ bis 15ₙ₋₁) sowie mit Addiereinheiten (16₁ bis 16ₙ₋₁) verbunden ist, und
zum anderen über einen Faltungscoder (10) und parallel hierzu über eine Start-Stop-Einheit (11) mit n Berechnungseinheiten (12₁ bis 12ₙ) verbunden ist, welchen (12₁ bis 12ₙ) eine die minimale Euklid'sche Distanz feststellende Einheit (14) nachgeschaltet ist, deren (n-1) Ausgänge mit den UND-Gliedern (15₁ bis 15ₙ₋₁) verbunden sind.

## Claims

1. Method for coding and decoding of binary data with the use of concatenated codes, wherein a coding of the data is performed at the transmission end by means of a code combination of a simple block code in the form of a single-parity-check (SPC) code and subsequently a convolutional code, and input signals are decoded at the reception end, characterised thereby, that the input signals are decoded at the reception end by means of parallelly connected Viterbi decoders and subsequently subject to a parity check by means of an SPC code and
a further treatment is performed in such a manner on ascertaining an error event that
after a convolutional coding of the sequence of the parity infringements and after a renewed convolutional coding of input signals, which have already been decoded already in the Viterbi decoders, by the convolutional code at the transmission end, modulo-2 sums are first formed of the sequences convolutionally coded anew and the convolutionally coded sequence of the parity infringements,
a change in Euclidean distances between sequences of the untreated analog input signals and the sequences convolutionally coded anew on the one hand and in Euclidean distances between sequences of the untreated analog input signals and the modulo-2 sums just formed on the other hand is determined subsequently and,
finally after searching and ascertaining the minimum of the changes in all Euclidean distances and with the aid of the convolutionally coded sequence of the parity infringements, bits in one of the sequences decoded by means of the Viterbi decoders are inverted for error correction.

2. Equipment for the performance of the method according to claim 1, in which a multiplexer (4) is connected downstream of n convolutional coders (3₁ to 3ₙ) and these to (3₁ to 3ₙ) are connected downstream of an [(n-1)/n] SPC coder (1) by way of a demultiplexer (4) at the transmission end and n soft-decision Viterbi decoders (7ₐ to 7ₙ) are connected downstream of a quantising unit and a demultiplexer (6) at the reception end, characterised thereby, that the outputs of the n soft-decision Viterbi decoders (7ₐ to 7ₙ) are connected with a parity check unit (9) as well as parallelly thereto with n convolutional decoders to (8₁ to 8ₙ) and (n-1) data buffers (13₁ to 13ₙ₋₁), the output of the parity check unit (9) is connected on the one hand by way of a data buffer (15) with (n-1) AND members (15₁ to 15ₙ₋₁) as well as with adding units (16₁ to 16ₙ₋₁) and on the other hand by way of a convolutional coder (10) and parallelly thereto by way of a start-stop unit (11) with n computing units (12₁ to 12ₙ), downstream of which (12₁ to 12ₙ) is connected the unit (14), which ascertains the minimum Euclidean distance and the (n-1) outputs of which are connected with the AND members (15₁ to 15ₙ₋₁).

## Revendications

1. Procédé pour le codage et le décodage de données binaires en utilisant des codes à enchaînement, sur le côté émission un codage des données s'effectuant au moyen d'une combinaison de codes à partir d'un code bloc simple sous forme d'un code de contrôle de parité simple (CPS) et consécutivement à un code de convolution, et en décodant sur le côté réception les signaux d'arrivée, caractérisé en ce que sur le côté réception, les signaux d'arrivée sont décodés au moyen d'un décodeur Viterbi monté en parallèle et sont ensuite soumis à un contrôle de parité au moyen d'un code CPS, et
lors de la constatation d'un cas d'erreur, on procède à un retraitement de telle sorte qu'après un décodage de convolution de la séquence des fautes de parité et après un nouveau codage de convolution des signaux d'arrivée déjà décodés dans les décodeurs Viterbi avec les codes de convolution du côté émission, on forme d'abord des sommes modulo-2 à partir des séquences à nouveau codées en convolution et de la séquence codée en convolution des erreurs de parité,
consécutivement, on détermine d'une part la modification des distances euclidiennes entre les séquences des signaux d'arrivée analogiques non traités et les séquences à nouveau codées en convolution et d'autre part des distances euclidiennes entre les séquences des signaux d'entrée analogiques non traités et des sommes modulo-2 qui viennent juste d'être constituées, et
pour finir, après la recherche et la constatation du minimum des modifications de toutes les distances euclidiennes et à l'aide de la séquence codée en convolution des erreurs de parité pour la correction d'erreurs, on inverse les éléments binaires dans l'une des séquences décodées au moyen du décodeur Viterbi.

2. Dispositif pour la réalisation du procédé selon la revendication 1, dans lequel sur le côté émission en aval d'un codeur CPS [(n-1)/n] (1) par l'intermédiaire d'un démultiplexeur (2) sont montés des codeurs de convolution n (3₁ à 3ₙ) et en aval de ces codeurs (3₁ à 3ₙ) est monté un multiplexeur (4), et sur le côté réception sont montés en aval d'une unité de quantification et d'un démultiplexeur (6) n décodeurs Viterbi à décision pondérée (7ₐ à 7ₙ) caractérisé en ce que
les sorties des n décodeurs Viterbi à décision pondérée ou à décisions quantiques (7ₐ à 7ₙ) sont reliées à une unité de contrôle de parité (9) ainsi que parallèlement à celle-ci, à n codeurs de convolution (8₁ à 8ₙ) et à (n-1) tampons de données (13₁ à 13ₙ₋₁),
la sortie de l'unité de contrôle de parité (9) est reliée d'une part, par un tampon de données (15), à (n-1) des éléments ET (15₁ à 15ₙ₋₁) ainsi qu'à des unités d'addition (16₁ à 16ₙ₋₁), et
d'autre part, par un codeur de convolution (10) et parallèlement à celui-ci, par une unité démarrage-arrêt (11), elle est reliée à n unités de calcul (12₁ à 12ₙ), en aval desquelles unités (12₁ à 12ₙ) est montée l'unité (14) déterminant la distance euclidienne minimale, dont les (n-1) sorties sont reliées aux éléments ET (15₁ à 15ₙ₋₁).
